# EUROPÄISCHE PATENTSCHRIFT

(11) **EP 3 909 134 B1**
(45) Veröffentlichungstag und Bekanntmachung des Hinweises auf die Patenterteilung: **14.10.2026**
(21) Anmeldenummer: 20749865.0
(22) Anmeldetag: 29.07.2020
(51) Int. Cl.: H03K 17/96, H03K 17/955

(54) **SCHALTBEDIENELEMENT**
SWITCHING OPERATING ELEMENT
ÉLÉMENT DE COMMANDE DE COMMUTATION

(30) Priorität: 16.08.2019 DE 102019005714
(43) Veröffentlichungstag der Anmeldung: 17.11.2021
(73) Patentinhaber: Marquardt GmbH, 78604 Rietheim-Weilheim (DE)
(72) Erfinder: MINK, Achim, 78652 Deißlingen (DE); STÄRK, Alexander, 88605 Meßkirch (DE); DOLD, Michael, 78048 Villingen-Schwenningen (DE); BECHER, Andreas, 78052 Villingen-Schwenningen (DE); ABT, Christof, 78573 Wurmlingen (DE); SCHUSTER, Dominik, 78532 Tuttlingen (DE)
(74) Vertreter: Staeger & Sperling Partnerschaftsgesellschaft mbB
(86) Internationale Anmeldenummer: PCT/EP2020/071439
(87) Internationale Veröffentlichungsnummer: WO 2021/032433

(56) Entgegenhaltungen:
- WO-A1-2018/164853
- DE-B3- 102018 117 901
- US-A1- 2009 219 039
- US-A1- 2013 076 374
- US-A1- 2017 350 169
- US-A1- 2018 135 339
- US-A1- 2018 260 049

## Beschreibung

Die Erfindung geht aus von einem Schaltbedienelement nach dem Oberbegriff des Patentanspruchs 1.

Solche Schaltbedienelemente werden in Kraftfahrzeugen zur Bedienung unterschiedlichster Funktionen durch einen Benutzer eingesetzt. Beispielsweise kann das Schaltbedienelement in der Art eines Schaltbedienfeldes im Lenkrad, im Armaturenbrett, in der Mittelkonsole, in einer Armablage o. dgl. im Kraftfahrzeug eingesetzt werden. Insbesondere findet ein solches Schaltbedienelement auch Verwendung als Türgriffsensor zur Detektierung der Bedienung zur Ent- und/oder Verriegelung der Autotüre durch einen Benutzer.

Relevanter Stand der Technik auf diesem Gebiet ist insbesondere durch die Schriften US 2017/350169 A1, US 2009/219039 A1 und DE 10 2018 117 901 B3 gegeben.

Ein derartiges Schaltbedienelement in der Art eines Schaltbedienfeldes weist eine Betätigungsfläche für die manuelle Einwirkung mittels eines Elements durch den Benutzer auf. Insbesondere kann es sich bei dem Element um eine menschliche Hand handeln, mit deren Hilfe die Betätigung des Schaltbedienelementes erfolgt. Die Betätigungsfläche wirkt dabei mit einem kapazitiv arbeitenden Sensor derart zusammen, dass der Sensor bei Annäherung des Elements an die Betätigungsfläche und/oder bei Berührung der Betätigungsfläche mittels des Elements und/oder bei Druckeinwirkung mittels des Elements auf die Betätigungsfläche ein Signal erzeugt. Das Signal dient als Schalt- und/oder Steuersignal zum Schalten und/oder Auslösen einer zugeordneten Funktion im Kraftfahrzeug.

Der kapazitiv arbeitende Sensor umfasst einen elektrischen Schwingkreis, einen Signalgenerator zur Anregung des Schwingkreises mit einer Anregungsfrequenz und eine Messeinheit zur Messung eines Messwertes des Schwingkreises bei der Anregungsfrequenz. Und zwar misst die Messeinheit insbesondere die am Schwingkreis anliegende elektrische Spannung und/oder den im Schwingkreis fließenden elektrischen Strom als Messwert. Des Weiteren umfasst der Sensor eine Auswerteeinheit, die das Signal in Abhängigkeit von der Änderung des Messwertes bei Einwirkung des Elements auf die Betätigungsfläche erzeugt. Es hat sich herausgestellt, dass Verschmutzungen und/oder Wasserbeaufschlagung der Betätigungsfläche zu einer fehlerhaften Signalerzeugung und dadurch zur fehlerhaften Auslösung der zugeordneten Funktionen führen können.

Der Erfindung liegt die Aufgabe zugrunde, das Schaltbedienelement derart weiterzuentwickeln, dass die Funktionssicherheit gesteigert ist. Insbesondere soll ein unerwünschtes Ansprechverhalten des kapazitiven Sensors auch bei Verschmutzungen und/oder bei Wassereinwirkung weitgehend vermieden sein.

Zur Lösung dieser Aufgabe wird ein Schaltbedienelement mit den Merkmalen des Hauptanspruchs sowie ein Verfahren gemäß dem nebengeordneten Anspruch vorgeschlagen.

Beim erfindungsgemäßen Schaltbedienelement wird der Schwingkreis mit einer ersten Anregungsfrequenz betrieben, die kleiner als die Resonanzfrequenz des Schwingkreises ist.

Insbesondere wird der Schwingkreis mit einer Anregungsfrequenz, die in einem Bereich von ca. 6 % bis 4 % unterhalb der Resonanzfrequenz liegt, betrieben. In bevorzugter Weise ist die Anregungsfrequenz in etwa 5 % unterhalb der Resonanzfrequenz gewählt. Es hat sich in vorteilhafter Weise herausgestellt, dass ein solcherart betriebenes Schaltbedienelement weitgehend Wasser- und/oder Schmutzunempfindlich ist. Weitere Ausgestaltungen der Erfindung sind Gegenstand der Unteransprüche.

Eine Ausgestaltung, bei der ausschließlich die erste Anregungsfrequenz ausgewertet wird, fällt nicht unter den Gegenstand der Patentansprüche.

In einer weiteren Ausgestaltung, die sich durch besondere Einfachheit und/oder Funktionssicherheit auszeichnet, kann vorgesehen sein, dass die Auswerteeinheit das Signal lediglich dann erzeugt, wenn die Differenz zwischen dem Messwert bei der Anregungsfrequenz und dem Basis-Messwert für den unbeeinflussten Schwingkreis bei der Anregungsfrequenz einen vorgegebenen Basis-Schwellwert übersteigt. Für den Basis-Messwert wird der unbedämpfte Schwingkreis, bei dem also keine Einwirkung des Elements auf die Betätigungsfläche und/oder Störungen, wie beispielsweise Einwirkung von Wasser, Schmutz o. dgl., vorliegen, herangezogen. Ausgehend vom Basis-Schwellwert detektiert das Schaltbedienelement die Einwirkung des Elements, wenn eine Veränderung des Messwertes um mindestens den Basis-Schwellwert erfolgt. Auf diese Art und Weise werden fehlerhafte Auslösungen des Schaltbedienelementes vermieden. Hierbei kann vom ausgekoppelten Signal des Schwingkreises, also vom Messwert, in der Auswerteeinheit eine sogenannte Baseline gebildet werden. Somit gibt es keine feste Detektionsschwelle sondern eine dynamische Detektionsschwelle für die Bedienung des Schaltbedienelements, wobei die dynamische Detektionsschwelle aus der Baseline plus dem Basis-Schwellwert in der Art eines Threshold gebildet ist.

Zur weiteren Steigerung der Funktionssicherheit für das Schaltbedienelement ist erfindungsgemäß vorgesehen, dass der Signalgenerator den Schwingkreis mit einer weiteren Anregungsfrequenz anregt. Insbesondere kann die weitere Anregungsfrequenz in etwa der Resonanzfrequenz des Schwingkreises entsprechen. Des Weiteren misst die Messeinheit einen weiteren Messwert bei der weiteren Anregungsfrequenz. Die Auswerteeinheit erzeugt das Signal lediglich dann, wenn die Differenz zwischen dem weiteren Messwert und dem Grenz-Messwert für den wiederum unbeeinflussten Schwingkreis bei der weiteren Anregungsfrequenz einen vorgegebenen Grenz-Schwellwert unterschreitet. Mit anderen Worten wird die Signaländerung des Schwingkreises beim Betrieb mit der Messfrequenz mit der Signaländerung des Schwingkreises beim Betrieb mit der Resonanzfrequenz verglichen. Dadurch kann eine entsprechende Belastung mit Wasser und/oder Schmutz auch bei Überschreiten der Auslöseschwelle beim Betrieb mit der Messfrequenz erkannt werden, da dann die Signalabnahme beim Betrieb mit der Resonanzfrequenz deutlich größer ist. In vorteilhafter Weise kann somit eine vermeintliche Bedienung des Schaltbedienelements, die durch eine starke Belastung mittels Wasser und/oder Schmutz hervorgerufen wird, erkannt und eine Fehlfunktion des Schaltbedienelements verhindert werden.

Des Weiteren kann zwecks Verbesserung der Betriebssicherheit vorgesehen sein, dass der Signalgenerator den Schwingkreis mit wenigstens einer in der Nähe zur Anregungsfrequenz liegenden, noch weiteren Anregungsfrequenz anregt. Insbesondere kann diese noch weitere Anregungsfrequenz in etwa ±0,1 % bis ±0,6 % von der Anregungsfrequenz, und zwar bevorzugterweise in etwa ±0,3 % bis ±0,6 % von der Anregungsfrequenz entfernt sein. Die Messeinheit misst dann einen noch weiteren Messwert bei der noch weiteren Anregungsfrequenz. Die Auswerteeinheit erzeugt das Signal lediglich dann, wenn die Differenz zwischen dem noch weiteren Messwert und dem Messwert geringfügig ist. Insbesondere kann ein Höchstwert vorgesehen sein, so dass das Signal nur dann erzeugt wird, wenn die Differenz kleiner als der vorgegebene Höchstwert ist. Mit anderen Worten werden somit mehrere nahe beieinanderliegenden Messfrequenzen betrachtet. Beispielsweise wird bei einer oder zwei zusätzlichen Frequenzen sehr nahe zur Messfreqeuenz gemessen. Sind die Änderungen für die Messwerte bei diesen zusätzlichen Frequenzen im Wesentlichen vergleichbar zur Änderung des Messwertes bei der Messfrequenz, beispielsweise leicht ansteigend, so handelt es sich um eine Bedienung des Schaltbedienelements. Sind diese hingegen stark schwankend, insbesondere sowohl positiv und negativ, so deutet das auf einen Einfluss von Wasser und/oder Schmutz hin. In diesem Fall unterbleibt dann die Erzeugung des Signals.

In einfacher Art und Weise kann der Schwingkreis eine Induktivität und mindestens eine Kapazität umfassen. In weiterer kostengünstiger sowie auch kompakter Ausgestaltung können die Kapazität und/oder die Induktivität als gedruckte Schaltungsbestandteile gebildet sein. Zweckmäßigerweise sind die Kapazität und/oder die Induktivität auf einer Leiterplatte angeordnet. Des Weiteren kann die Betätigungsfläche in der Art einer Sensorelektrode ein Bestandteil der Kapazität sein. Schließlich kann zum Schutz des Schaltbedienelements ein Gehäuse mit einer Gehäusewand vorgesehen sein. Dabei kann die Gehäusewand die Betätigungsfläche, insbesondere in der Art einer Koppelkapazität zur Umgebung, ausbilden.

In weiterer Ausgestaltung des Schaltbedienelements kann eine Steuer- und/oder Kontrolleinheit vorgesehen sein. Zweckmäßigerweise kann die Steuer- und/oder Kontrolleinheit die Anregungsfrequenz am Signalgenerator einstellen und damit zum Betrieb des Schaltelements dienen. In kompakter Ausgestaltung kann die Auswerteeinheit von der Steuer- und/oder Kontrolleinheit gebildet sein. In kostengünstiger Art und Weise kann es sich bei der Steuer- und/oder Kontrolleinheit um einen Mikrocontroller, einen Mikroprozessor o. dgl. handeln.

In einer bevorzugten Anwendung für das Schaltbedienelement kann ein Antrieb für die Bewegung eines Verschlusselements, insbesondere für dessen Öffnung vorgesehen sein. Bei dem Verschlusselement kann es sich um eine Türe, wie eine Autotüre, eine Heckklappe, eine Frontklappe o. dgl. eines Kraftfahrzeugs handeln. Das vom Schaltbedienelement bei Bedienung des Benutzers erzeugte Signal kann dann den Antrieb für das Verschlusselement ansteuern.

Die Erfindung stellt weiterhin ein Verfahren zur Betrieb eines kapazitiven Sensors mit einem elektrischen Schwingkreis, der insbesondere für ein in der Art eines Schaltbedienfeldes ausgebildetes Schaltbedienelement vorgesehen ist, bereit. Bei einem solchen Schaltbedienelement wird auf eine Betätigungsfläche des Schaltbedienelements mittels eines Elements, bei dem es sich insbesondere um eine menschliche Hand handelt, eingewirkt. Und zwar erfolgt die Einwirkung derart, dass bei Annäherung des Elements an die Betätigungsfläche und/oder bei Berührung der Betätigungsfläche mittels des Elements und/oder bei Druckeinwirkung mittels des Elements auf die Betätigungsfläche ein Signal erzeugbar ist. Hierfür wird der Schwingkreis mit einer Anregungsfrequenz angeregt, und es wird ein Messwert des Schwingkreises bei der Anregungsfrequenz, und zwar insbesondere die am Schwingkreis anliegenden elektrischen Spannung und/oder der im Schwingkreis fließende elektrische Strom, gemessen. Die Änderung des Messwertes, die bei Einwirkung des Elements auf die Betätigungsfläche erfasst wird, wird dann zur Erzeugung des Signals ausgewertet. Erfindungsgemäß wird die Anregungsfrequenz kleiner als die Resonanzfrequenz des Schwingkreises gewählt. Insbesondere wird die Anregungsfrequenz in einem Bereich von ca. 6 % bis 4 % unterhalb der Resonanzfrequenz, und zwar bevorzugterweise in etwa um 5 % unterhalb der Resonanzfrequenz, gewählt.

In weiterer Ausgestaltung des Betriebsverfahrens für den kapazitiven Sensor wird das Signal lediglich dann erzeugt, wenn die Differenz zwischen dem Messwert bei der Anregungsfrequenz und dem Basis-Messwert für den unbeeinflussten Schwingkreis bei der Anregungsfrequenz einen vorgegebenen Basis-Schwellwert überschreitet. Mit unbeeinflussten Schwingkreis ist wiederum ein Schwingkreis bezeichnet, bei dem keine Einwirkung des Elements auf die Betätigungsfläche vorliegt sowie auch kein Wasser und/oder kein Schmutz an der Betätigungsfläche vorhanden ist.

Des Weiteren wird zwecks Verbesserung der Betriebs- und/oder Funktionssicherheit der Schwingkreis mit einer weiteren Anregungsfrequenz angeregt. Insbesondere kann für die weitere Anregungsfrequenz in etwa die Resonanzfrequenz des Schwingkreises gewählt werden. Es wird dann ein weiterer Messwert bei der weiteren Anregungsfrequenz gemessen. Das Signal wird lediglich dann erzeugt, wenn die Differenz zwischen dem weiteren Messwert und dem Grenz-Messwert für den unbeeinflussten Schwingkreis bei der weiteren Anregungsfrequenz einen vorgegebenen Grenz-Schwellwert unterschreitet.

Für eine besonders bevorzugte Ausgestaltung der Erfindung ist nachfolgendes festzustellen.

Es soll ein kapazitiver Sensor hinsichtlich eines unerwünschten Ansprechverhaltens auf Verschmutzungen und/oder Wasserbeaufschlagung verbessert werden. Insbesondere soll ein verbessertes Verfahren zur Messung und Auswertung der mittels eines LC(Induktivität / Kapazität)-Schwingkreises erzeugten Signale angegeben werden.

Kapazitive Annäherungs- und/oder Berührungssensoren werden im Fahrzeugaußenbereich in verschiedenen Applikationen eingesetzt. Beispielsweise kann es sich um Sensoren, die im Türaußengriff verbaut beziehungsweise integriert sind, um Sensoren im Unterbodenbereich der Heckklappe o. dgl. handeln. Diese Sensoren detektieren eine menschliche Annäherung beziehungsweise ein Berühren des Außengehäuses mittels einer Messung der elektrischen Kapazität. Das hauptsächlich verwendete Wirkprinzip zur Kapazitätsmessung ist das Ladungstransferverfahren, bei dem elektrische Ladung von der elektrischen Auswerteeinheit auf die Sensorelektrode umgeladen wird. Eine Änderung des Kapazitätsverhältnisses intern und/oder extern ist dann das Detektionskriterium. Applikations- und/oder Bauartbedingt ist die zu detektierende Kapazitätsänderung jedoch sehr gering, sie liegt im Bereich von in etwa 100 fF(Femtofarad) bis 1 pF (Picofarad). Als kritisch hat es sich hier herausgestellt, diese sehr kleinen Änderungen unter allen Umweltbedingungen sicher und/oder reproduzierbar zu erkennen.

Erfindungsgemäß ist der kapazitive Sensor durch einen Schwingkreis, der eine Anordnung von mindestens einer Induktivität und mindestens einer Kapazität umfasst, gebildet. Die Kapazität und/oder auch die Induktivität können als passive Bauteile oder als gedruckte Schaltungsteile realisiert werden. Bei entsprechend eingeschränkten Platzverhältnissen kann ein Einkoppeln über eine Erregerelektrode vorgenommen sein. Die Sensorelektrode ist Bestandteil dieses Schaltungsteils und hat einen kapazitiven Anteil an dem Gesamtsystem. Der Schwingkreis wird durch eine Erregerschaltung mit einer definierten Frequenz angeregt. Die Frequenz ist dabei von der Erregerschaltung variabel einstellbar und wird mittels einer Kontrolleinheit eingestellt. Mittels einer Auskoppelschaltung wird das Signal aus dem Schwingkreis ausgekoppelt und der Kontrolleinheit zur Auswertung zugeführt. Die Gehäusewand bildet zusammen mit der Sensorelektrode eine Koppelkapazität zur Umgebung, wobei die maximale Kapazitätsänderung, die der Sensor erfahren kann, durch diese Koppelkapazität bestimmt wird.

Die Kontrolleinheit wertet die Signalhöhe des ausgekoppelten Signals aus. Dabei wird vom ausgekoppelten Signal in der Kontrolleinheit eine sogenannte Baseline gebildet. Somit gibt es keine feste Detektionsschwelle sondern eine dynamische Detektionsschwelle, die von der Baseline plus einem Threshold gebildet ist. Das Sensorsignal soll sich nun durch externe Umwelteinflüsse, wie Feuchtigkeit, Wasseransammlungen, Regen, Schnee, Schmutzablagerungen o. dgl., nicht beziehungsweise nur sehr geringfügig beeinflussen lassen, um einen sicheren und/oder fehlauslösungsfreien Betrieb zu gewährleisten.

Wie ermittelt wurde, verschiebt sich die Resonanzkurve für den Schwingkreis bei externer kapazitiver Belastung, welche durch eine Annäherung beziehungsweise durch das Berühren mittels einer menschlichen Extremität hervorgerufen wird, zu niedrigeren Frequenzen. Die zu detektierende Verschiebung kann dabei sehr klein sein. Maximal kann sich die Resonanzfrequenz zu einer Frequenz verschieben, die durch eine Reihenschaltung der Koppelkapazität und der Berührkapazität gebildet wird. Die Koppelkapazität bestimmt aufgrund ihres kleinen Wertes die maximale Änderung.

Wie weiter ermittelt wurde, wird die Resonanzkurve bei externer resistiver Belastung, welche durch externe Umwelteinflüsse hervorgerufen wird, gedämpft. Das bedeutet, die Amplitude der Resonanzfrequenz nimmt zunächst ab, ohne dass sich die Resonanz verschiebt. Wird der externe Widerstand jedoch kleiner, so verschiebt sich dann die Resonanzfrequenz zu niedrigeren Frequenzen hin und die Amplitude der Resonanzfrequenz nimmt wieder zu. Des Weiteren ist gefunden, dass die Änderung der Signalamplitude bei dem Zweig oberhalb der Resonanzfrequenz des Grundsignals immer zu kleineren Werten erfolgt. Hingegen nimmt bei dem unterhalb der Resonanzfrequenz verlaufenden Zweig der Resonanzkurve bei rein kapazitiver Belastung der Signalwert beziehungsweise die Signalamplitude zu, während die Signalamplitude bei resistiver Belastung aufgrund des Dämpfungsverhaltens abnimmt und nur bei kleinen Widerstandswerten wieder ansteigt.

Demzufolge ist ein Heranziehen des oberhalb der Resonanzfrequenz verlaufenden Zweiges der Resonanzkurve nicht gewünscht. Vielmehr wird für die Messung der unterhalb der Resonanzfrequenz verlaufende Zweig der Resonanzkurve gewählt.

In weiterer Ausgestaltung kann der Schwingkreis auf mindestens zwei Frequenzen betrieben werden. Eine davon ist die Resonanzfrequenz Fres des unbedämpften Schwingkreises und die andere Frequenz ist die um einen definierten Betrag niedriger liegende Frequenz Fmess1. Die Signaländerung der Messfrequenz Fmess1 wird dann mit der Abnahme bei der Resonanzfrequenz Fres verglichen, d.h. es wird ein "Ins-Verhältnis-Setzen" der Delta-Werte für die Signalamplituden vorgenommen. Dadurch kann eine kleine resistive Belastung auch bei Überschreiten der Auslöseschwelle bei der Frequenz Fmess1 erkannt werden, da die Abnahme in der Resonanzfrequenz Fres hier dann deutlich größer ist.

In nochmals weiterer Ausgestaltung können mehrere nahe beieinanderliegende Messfrequenzen betrachtet werden. Und zwar wird auf einer Frequenz Fhilf1 oder auch auf zwei zusätzlichen Frequenzen Fhilf1, Fhilf2 sehr nahe zur Fmess1 gemessen. Die Änderungen der Signalamplitude bei diesen Frequenzen Fhilf1 und/oder Fhilf2müssen vergleichbar zu derjenigen bei der Messfrequenz Fmess1 sein. Beispielsweise wird bei kapazitiver Belastung ein leichtes Ansteigen der Änderungen der Signalamplitude registriert, wohingegen sie bei resistiver Belastung stark schwanken, d.h. bei niederohmiger Belastung positiv und/oder negativ sein können.

In bevorzugter Weise werden dann folgende Frequenzen für den Betrieb des Schwingkreises gewählt:
- Fres: Resonanzfrequenz des unbetätigten Sensors bzw. Resonanzfrequenz des betätigten Sensors für die maximale Signaländerung.
- Fmess1: Unterhalb der Resonanzfrequenz des betätigten Sensors, und zwar insbesondere ca. 1 % bis 6 % unterhalb der Resonanzfrequenz.
- Fhilf1: Fmess1 - ca. 0,5 % von Fmess1.
- Fhilf2: Fmess1 + ca. 0,5 % von Fmess1.

Geschaffen ist durch die Erfindung ein Wasser- und/oder Schmutzunempfindlicher kapazitiver Sensor, insbesondere für Anwendungen im Fahrzeug-Außenbereich.

Die mit der Erfindung erzielten Vorteile bestehen insbesondere darin, dass das Schaltbedienelement eine gegenüber Umweltbedingten Störbeeinflussungen deutlich verbesserte Immunität aufweist. Beispielsweise treten bis zu einem Wasser- und/oder Schmutzwiderstand von 5 KOHM keine Fehlauslösungen des Sensors auf. Des Weiteren erzielt das Schaltbedienelement eine Verbesserung von dessen Betriebs- und/oder Funktionssicherheit. Somit ist das Schaltbedienelement auch für sicherheitskritische Anwendungen, insbesondere im Außenbereich eines Kraftfahrzeugs, einsetzbar.

Ein Ausführungsbeispiel der Erfindung mit verschiedenen Weiterbildungen und Ausgestaltungen ist in den Zeichnungen dargestellt und wird im Folgenden näher beschrieben. Es zeigen
- Fig. 1: ein ein Schaltbedienelement aufweisendes Kraftfahrzeug mit einem im Außenbereich befindlichen Benutzer in schematischer Ansicht,
- Fig. 2: die nähere Ausgestaltung des einen elektrischen Schwingkreis umfassenden Schaltbedienelements aus Fig. 1,
- Fig. 3: das Schaltbedienelement wie in Fig. 2, wobei dieses mit Wasser und/oder Verschmutzungen beaufschlagt ist,
- Fig. 4: ein Diagramm für den Verlauf der an dem in Fig. 2 dargestellten Schwingkreis ermittelten Messwerten in Abhängigkeit von der Anregungsfrequenz für den Schwingkreis,
- Fig. 5: ein Diagramm für den Verlauf der an dem in Fig. 3 dargestellten Schwingkreis ermittelten Messwerten in Abhängigkeit von der Anregungsfrequenz für den Schwingkreis,
- Fig. 6: einen Ausschnitt aus dem Diagramm gemäß Fig. 5 in vergrößerter Darstellung,
- Fig. 7: das gemäß Fig. 2 weiter detaillierte Schaltbedienelement, und
- Fig. 8: das elektrische Ersatzschaltbild für das in Fig. 7 gezeigte Schaltbedienelement.

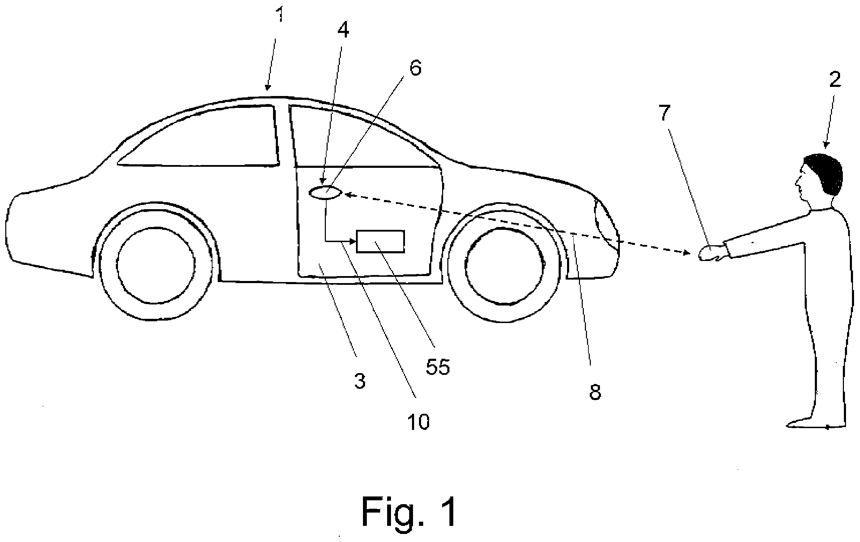

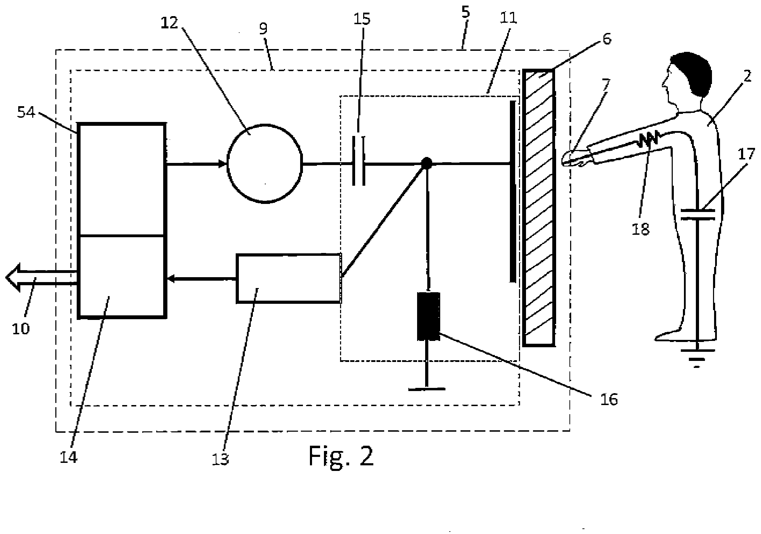

In Fig. 1 ist ein Kraftfahrzeug 1 mit einer Autotüre 3, die von einem Benutzer 2 geöffnet werden soll, zu sehen. Die Autotüre 3 weist einen Türgriff 4 mit einer Betätigungsfläche 6 auf, wobei der Benutzer 2 durch Berührung 8 der Betätigungsfläche 6 mittels seiner Hand 7 das Öffnen der Autotüre 3 auslöst. Zur Detektierung der Berührung 8 ist im Kraftfahrzeug 1, und zwar vorliegend im Türgriff 4, ein Schaltbedienelement 5 (siehe Fig. 2) angeordnet.

Das in Fig. 2 näher gezeigte Schaltbedienelement 5 in der Art eines Schaltbedienfeldes umfasst die Betätigungsfläche 6 zur manuellen Einwirkung mittels der menschlichen Hand 7. Selbstverständlich kann anstelle der menschlichen Hand auch ein sonstiges Element 7, beispielsweise ein Stift o. dgl., für die Eingabe Verwendung finden. Mit der Betätigungsfläche 6 wirkt ein kapazitiv arbeitender Sensor 9 derart zusammen, dass der Sensor 9 bei Annäherung des Elements 7 an die Betätigungsfläche 6 und/oder bei Berührung der Betätigungsfläche 6 mittels des Elements 7 und/oder bei Druckeinwirkung mittels des Elements 7 auf die Betätigungsfläche 6 ein Signal 10 erzeugt. Das Signal 10 dient dann wiederum zum Schalten und/oder Auslösen einer Funktion in der Art eines Schalt- und/oder Steuersignals. Vorliegend wird das Signal 10 an ein nicht weiter gezeigtes Steuergerät im Kraftfahrzeug 1 weitergeleitet, woraufhin das Steuergerät die Öffnung der Autotüre 3 bewirkt.

Der kapazitiv arbeitende Sensor 9 umfasst einen elektrischen Schwingkreis 11, einen Signalgenerator 12 zur Anregung des Schwingkreises 11 mit einer ersten Anregungsfrequenz fmess1, eine Messeinheit 13 zur Messung eines Messwertes beim Betrieb des Schwingkreises 11 bei der ersten Anregungsfrequenz fmess 1 und eine Auswerteeinheit 14 zur Erzeugung des Signals 10. Bei dem Messwert handelt es sich um die jeweilige am Schwingkreis 11 anliegende elektrische Spannung und/oder um den im Schwingkreis 11 fließenden elektrischen Strom bei dessen Betrieb. Bei entsprechender Änderung des Messwertes detektiert die Auswerteeinheit 14 die Einwirkung des Elements 7 auf die Betätigungsfläche 6 und erzeugt dann das Signal 10. Die Auswerteeinheit 14 nimmt somit die Erzeugung des Signals 10 in Abhängigkeit von der Änderung des Messwertes bei Einwirkung des Elements 7 auf die Betätigungsfläche 6 vor.

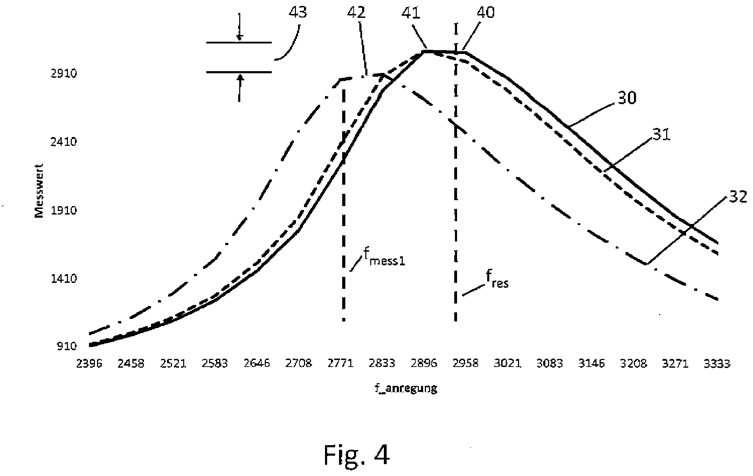

Der Schwingkreis 11 ist wiederum von einem elektrischen Kondensator 15 und einer Induktivität 16 gebildet. In Fig. 4 ist der Verlauf der von der Messeinheit 13 gemessenen Messwerte für den in Fig. 2 dargestellten Schwingkreis 11, bei dem die Betätigungsfläche 6 in idealer Weise trocken ist, in Abhängigkeit von der Anregungsfrequenz fanr näher dargestellt. Dabei ist auf der Abszisse die Frequenz in KHz sowie auf der Ordinate der Messwert in nicht näher spezifizierten Digital-Einheiten aufgetragen. Wie man erkennt, besitzt der Schwingkreis 11 eine Resonanzkurve 30, die eine Resonanz bei ca. 2,92 MHz aufweist. Dabei ist die Amplitude 40 für den Messwert im Resonanzpunkt am größten. Wird auf die Betätigungsfläche 6 mittels der menschlichen Hand 7 gemäß Fig. 2 eingewirkt, so verändert sich die im Schwingkreis 11 wirkende gesamte elektrische Kapazität, da die menschliche Hand 7 eine zusätzliche Kapazität 17 bildet. Neben der zusätzlichen Kapazität 17 besitzt die Hand 7 auch einen elektrischen Widerstand 18, welcher jedoch äußerst gering sowie ohne weiteren Einfluss vernachlässigbar ist. Aufgrund der Veränderung der im Schwingkreis 11 wirkenden Kapazität verschiebt sich damit die Resonanzkurve in Abhängigkeit von der Stärke der Berührung der Betätigungsfläche 6, und zwar über die Resonanzkurve 31 bei einer leichten Berührung bis zur Resonanzkurve 32 bei einer stärkeren Berührung. Wie man durch Vergleich zwischen den Resonanzkurven 30, 31, 32 erkennt, verschiebt sich dabei die Resonanzfrequenz fres zu kleineren Messwerten und die Amplituden 41, 42 der Messwerte im Resonanzpunkt nimmt ebenfalls ab. Herkömmlicherweise wird daher die Änderung der Amplituden 40, 41, 42 im Resonanzpunkt zur Erkennung der Berührung verwendet. Beispielsweise wird das Signal 10 erzeugt, wenn die Differenz 43 der Amplituden 40, 41 bzw. 42 einen vorgegebenen Schwellwert überschreitet.

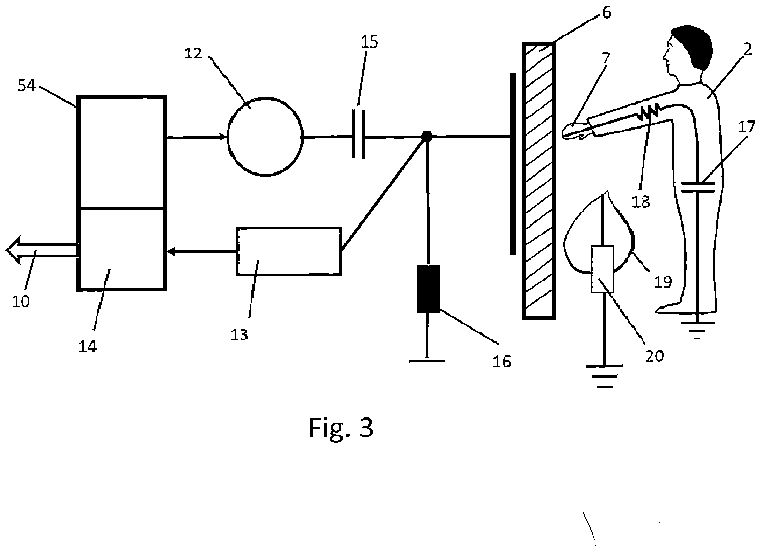

Ist die Betätigungsfläche 6 jedoch nass, so ändert sich das Verhalten des Schwingkreises 11. Wie in Fig. 3 näher gezeigt ist, ist die Betätigungsfläche 6 mit Wassertropfen 19 benetzt. Die Wassertropfen 19 besitzen einen elektrisch resistiven Widerstand 20, der wiederum das Schwingungsverhalten des Schwingkreises 11 in erheblichem Maße beeinflusst. Ebenso besitzen Verschmutzungen einen resistiven, das Schwingungsverhalten beeinflussenden Anteil, wobei jedoch der Einfachheit halber im Folgenden lediglich Wasser 19 näher betrachtet ist.

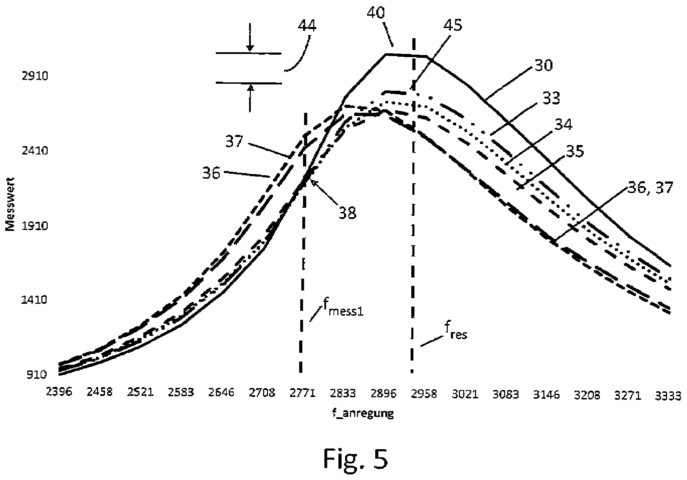

In Fig. 5 ist der Einfluss von Wasser 19 an der Betätigungsfläche 6 näher zu sehen. Bei trockener Betätigungsfläche 6 liegt wiederum die bereits in Fig. 4 dargestellte Resonanzkurve 30 vor. Wird Wasser 19 auf die Betätigungsfläche 6 aufgebracht, so verschieben sich die Resonanzkurven zu geringeren Amplituden. Bei leichter Benetzung mit Wasser 19 erhält man die Resonanzkurve 33, bei etwas größerer Benetzung die Resonanzkurve 34 und bei mittlerer Benetzung die Resonanzkurve 35. Schließlich erhält man bei starker Benetzung die Resonanzkurve 36 und bei äußerst starker Benetzung, beispielsweise durch Eintauchen in Wasser 19, die Resonanzkurve 37. Dabei verschiebt sich bei der starken Benetzung mit Wasser 19 zusätzlich der Resonanzpunkt für die Resonanzkurven 36, 37 gegenüber der Resonanzkurve 30 für die trockene Betätigungsfläche 6. Wie ersichtlich ist, ist bereits bei Vorliegen der Differenz 44 der Amplitude 40 für die Resonanzkurve 30 ohne Einfluss von Wasser 19 und der Amplitude 45 für die Resonanzkurve 33 bei leichter Benetzung mit Wasser 19 nicht mehr unterscheidbar, ob es sich um die Berührung der Betätigungsfläche 6 oder um eine mit Wasser 19 benetzte Betätigungsfläche 6 handelt. Vielmehr kann es in einem solchen Falle zur fehlerhaften Erzeugung des Signals 10 kommen, was wiederum eine Fehlfunktion des Schaltbedienelements 5 nach sich zieht.

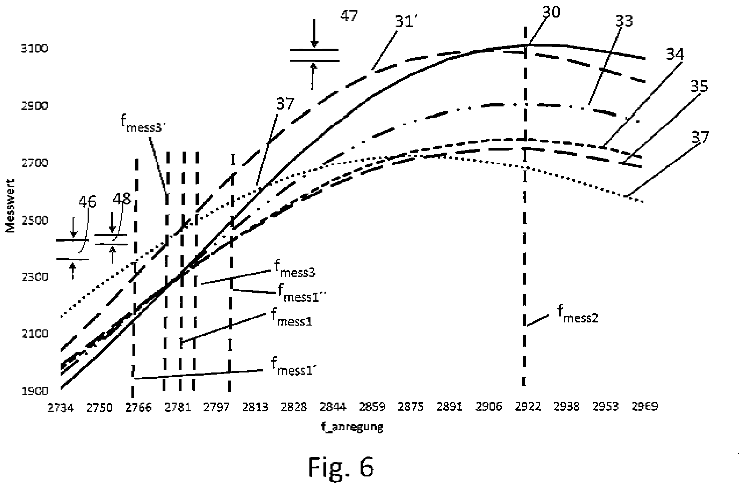

Bei der Erfindung ist nun die Erkenntnis gewonnen, wie man anhand der Fig. 5 erkennt, dass der bezüglich des Resonanzpunktes linke Zweig 38 der Resonanzkurven 33, 34, 35 bei Benetzung mit Wasser 19 im Wesentlichen deckungsgleich mit dem linken Zweig 38 der Resonanzkurve 30 für die trockene Betätigungsfläche 6 verläuft. Damit ist das Vorhandensein von Wasser 19 auf der Betätigungsfläche 6 ohne wesentlichen Einfluss auf das Schwingungsverhalten des Schwingkreises 11 bezüglich des linken Zweiges 38, womit die Berührung der Betätigungsfläche 6 mittels der Hand 6 detektierbar ist, ohne die beschriebene Fehlfunktion befürchten zu müssen. Erfindungsgemäß wird somit für den Betrieb des Schwingkreises 11 die erste Anregungsfrequenz fmess1 auf dem linken Zweig 38 gewählt, also derart dass die erste Anregungsfrequenz fmess1 kleiner als die Resonanzfrequenz fres des Schwingkreises 11 ist. Um eine Berührung der Betätigungsfläche 6 mit Sicherheit zu detektieren, erzeugt die Auswerteeinheit 14 das Signal 10 lediglich dann, wenn die Differenz 46 (siehe hierzu Fig. 6) zwischen dem Messwert bei der ersten Anregungsfrequenz fmess1 auf der Resonanzkurve 31' bei Berührung der mit Wasser 19 benetzten Betätigungsfläche und dem Basis-Messwert auf der Resonanzkurve 30 für den unbeeinflussten Schwingkreis 11 bei der ersten Anregungsfrequenz fmess1 einen vorgegebenen Basis-Schwellwert übersteigt. Mit unbeeinflussten Schwingkreis ist dabei bezeichnet, dass weder eine Einwirkung des Elements 7 auf die Betätigungsfläche 6 noch eine Benetzung der Betätigungsfläche 6 mit Wasser 19 vorliegt. Mit Resonanzkurve 31' ist die bei Berührung der benetzten Betätigungfläche 6 mittels des Elements 7 vorliegende Resonanzkurve des Schwingkreises 11 bezeichnet.

Der Bereich um die erste Anregungsfrequenz fmess1 auf dem linken Zweig 38 aus Fig. 5 ist für einen Schwingkreis 11 mit einer Güte für die L(Spule 16)/C(Kondensator 15)-Kombination von ca. 8 in Fig. 6 vergrößert dargestellt. Wie man anhand der Fig. 6 erkennt ist die Deckungsgleichheit der Resonanzkurven 30, 33, 34, 35 besonders herausragend in einem Intervall von fmess1' bis fmess1", wobei fmess1' in etwa 6 % sowie fmess1" in etwa 4 % unterhalb der Resonanzfrequenz fres für die Resonanzkurve 30 bei der unbeeinflussten Betätigungsfläche 6 liegt. Zwecks weiterer Steigerung der Betriebssicherheit für das Schaltbedienelement 5 kann es sich daher anbieten, dass die erste Anregungsfrequenz fmess1 in einem Bereich von 6 % bis 4 % unterhalb der Resonanzfrequenz fres gewählt ist. Bevorzugterweise kann die erste Anregungsfrequenz fmess1 bei in etwa 5 % unterhalb der Resonanzfrequenz fres gewählt sein.

Wie man weiterhin der Fig. 6 entnimmt, kann bei äußerst starker Benetzung der Betätigungsfläche 6, beispielsweise wenn das Kraftfahrzeug 1 unter außergewöhnlichen Umständen einem Wolkenbruch ausgesetzt ist, die Resonanzkurve 37 auch im Intervall von fmess1' bis fmess1" etwas von den übrigen Resonanzkurven 30, 33, 34, 35 abweichen. Um auch in solch einem außergewöhnlichen Fall eine Fehlfunktion des Schaltbedienelements 5 zu vermeiden ist vorgesehen, dass der Signalgenerator 12 den Schwingkreis 11 mit einer weiteren, zweiten Anregungsfrequenz fmess2 anregt. Dabei hat es sich als zweckmäßig erwiesen, dass insbesondere die weitere, zweite Anregungsfrequenz fmess2 in etwa der Resonanzfrequenz fres des Schwingkreises 11 entspricht. Die Messeinheit 13 misst dann einen weiteren, zweiten Messwert bei der weiteren, zweiten Anregungsfrequenz fmess2. Die Auswerteeinheit 14 erzeugt das Signal 10 lediglich dann, wenn die Differenz 47 zwischen dem weiteren, zweiten Messwert auf der Resonanzkurve 31' und dem Grenz-Messwert auf der Resonanzkurve 30 für den wiederum unbeeinflussten Schwingkreis 11 bei der weiteren, zweiten Anregungsfrequenz fmess2 einen vorgegebenen Grenz-Schwellwert unterschreitet. Dadurch kann eine kleine resistive Belastung des Schwingkreises 11 auch bei Überschreiten des Basis-Schwellwerts durch die Differenz 46 erkannt werden.

Um die Fehlersicherheit für das Schaltbedienelement 5 weiter zu steigern, kann eine zusätzliche Plausibilitätskontrolle für die den Basis-Schwellwert überschreitende Differenz 46 durchgeführt werden. Hierzu regt der Signalgenerator 12 den Schwingkreis 11 mit wenigstens einer, in der Nähe zur ersten Anregungsfrequenz fmess1 liegenden, weiteren dritten Anregungsfrequenz fmess3 an. Die Messeinheit 13 misst dann einen noch weiteren, dritten Messwert bei der noch weiteren, dritten Anregungsfrequenz fmess3. Die Auswerteeinheit 14 erzeugt das Signal 10 lediglich dann, wenn die Differenz 48 zwischen dem noch weiteren, dritten Messwert und dem ersten Messwert bei der ersten Anregungsfrequenz fmess1 geringfügig ist, insbesondere kleiner als ein vorgegebener Höchstwert ist.

Zweckmäßigerweise kann bei dieser Plausibilitätskontrolle überprüft werden, ob die Differenz 48 zwischen dem noch weiteren, dritten Messwert und dem ersten Messwert kleiner als ein vorgegebener Höchstwert ist. Lediglich in diesem Fall wird das Signal 10 erzeugt. Eine weitere Verbesserung lässt sich dadurch erzielen, indem der Schwingkreis 10 nicht nur mit einer dritten Anregungsfrequenz fmess3 sondern mit mehreren, in der Nähe zur ersten Anregungsfrequenz fmess1 liegenden, dritten Anregungsfrequenzen fmess3, fmess3' betrieben wird. Insbesondere kann die dritte Anregungsfrequenz fmess3, fmess3' in etwa ±0,1 % bis ±0,6 % von der ersten Anregungsfrequenz fmess1 entfernt sein. In bevorzugter Weise kann dabei die dritte Anregungsfrequenz fmess3, fmess3' in etwa ±0,3 % bis ±0,6 % von der ersten Anregungsfrequenz fmess1 entfernt sein. Der beschriebenen Plausibilitätskontrolle liegt die mittels der Erfindung gewonnene Erkenntnis zugrunde, dass stark schwankende Messwerte bei nahe zur ersten Messfrequenz fmess1 liegenden, weiteren Frequenzen auf eine resistive Belastung des Schwingkreises 11 und damit auf den Einfluss von Wasser 19 auf die Betätigungsfläche 6 hindeuten.

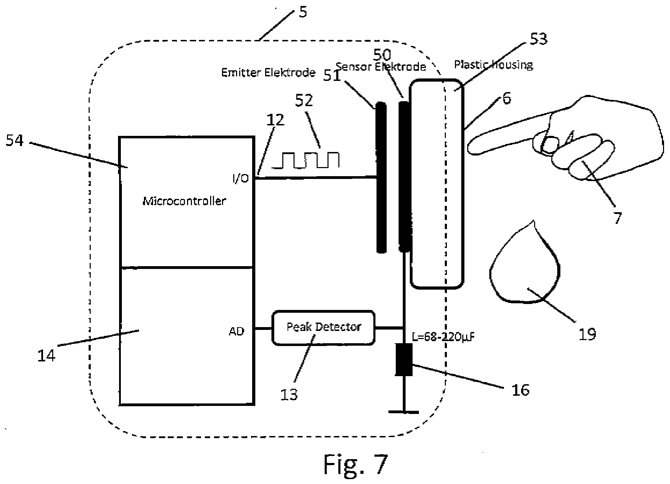

Wie bereits anhand der Fig. 2 erläutert, kann der Schwingkreis 11 eine Induktivität 16 und mindestens eine Kapazität 15 umfassen. Um das Schaltbedienelement 5 in kleinen Einbauräumen, beispielsweise im Türgriff 4 unterzubringen, können die Kapazität 15 und/oder die Induktivität 16 als gedruckte Schaltungsbestandteile gebildet sein. Zweckmäßigerweise können die Kapazität 15 und/oder die Induktivität 16 auf einer nicht weiter gezeigten Leiterplatte angeordnet sein. Wie weiter in Fig. 7 sehen ist, kann die Betätigungsfläche 6 in der Art einer Sensorelektrode 50 ein Bestandteil der Kapazität 15 sein, wobei eine mit dem Signalgerator 12 in Verbindung stehende Emitterelektrode 51 zur Anregung des Schwingkreises 11 mit den Anregungsfrequenzen 52 ein weiterer Bestandteil der Kapazität 15 ist. Für das Schaltbedienelement 5 ist ein Gehäuse 53 mit einer Gehäusewand 6 vorgesehen. Diese Gehäusewand bildet dann die Betätigungsfläche 6 aus.

Des Weiteren ist eine Steuer- und/oder Kontrolleinheit 54 vorgesehen. Die Steuer- und/oder Kontrolleinheit 54 stellt die jeweilige Anregungsfrequenz 52 am Signalgenerator 12 ein. Als Messeinheit 13 ist ein Peak Detector vorgesehen, der mit einem Analog-/Digital-Wandler in der Steuer- und/oder Kontrolleinheit 54 in Verbindung steht, so dass die Messwerte in digitaler Form der Auswerteeinheit 14, die ebenfalls von der Steuer- und/oder Kontrolleinheit 54 gebildet ist, zur weiteren Verarbeitung zur Verfügung stehen. In bevorzugter Weise kann es sich bei der Steuer- und/oder Kontrolleinheit 54 um einen Mikrocontroller, einen Mikroprozessor o. dgl. handeln. Bei dem Signalgenerator 12 und/oder der Messeinheit 13 und/oder der Auswerteeinheit 14 kann es sich um aus Hardware bestehende elektronische Schaltungen handeln, in bevorzugter Weise sind diese jedoch von in der Steuer- und/oder Kontrolleinheit 54 befindlicher Software gebildet.

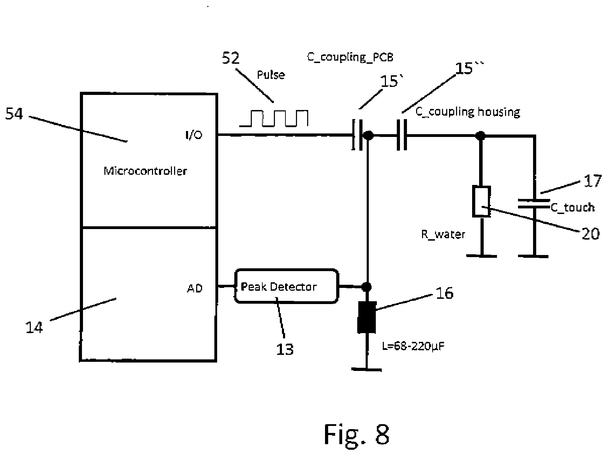

Wie weiter in Fig. 8 dargestellt ist, umfasst die Kapazität 15 zum einen die Kapazität 15' der Emitterelektrode 51 als Koppelkapazität und die Kapazität 15" der Sensorelektrode 50, die in der Art einer Koppelkapazität zur Umgebung von der Gehäusewand als Betätigungsfläche 6 gebildet ist. Des Weiteren bildet das Element 7 bei Einwirkung auf die Betätigungsfläche 6 eine weitere Kapazität 17. Schließlich bildet das die Betätigungsfläche 6 benetzende Wasser 19 einen elektrisch resistiven Widerstand 20. Wie weiter in Fig. 1 schematisch gezeigt ist, im Kraftfahrzeug 1 ein Antrieb 55 für die Bewegung der Autotüre 3 vorgesehen. Das vom Schaltbedienelement 5 erzeugte Schalt- und/oder Steuersignal 10 steuert dann den Antrieb 55 zur Öffnung der Autotüre 3 an.

### Bezugszeichen-Liste:

- 1:: Kraftfahrzeug
- 2:: Benutzer
- 3:: Autotüre
- 4:: Türgriff
- 5:: Schaltbedienelement
- 6:: Betätigungsfläche / Gehäusewand
- 7:: Hand (des Benutzers) / Element
- 8:: Berührung
- 9:: kapazitiver Sensor
- 10:: Signal / Schalt- und/oder Steuersignal
- 11:: (elektrischer) Schwingkreis
- 12:: Signalgenerator
- 13:: Messeinheit
- 14:: Auswerteeinheit
- 15:: Kondensator (von Schwingkreis) / Kapazität
- 15':: Kapazität (der Emitterelektrode)
- 15":: Kapazität (der Sensorelektrode)
- 16:: Induktivität (von Schwingkreis)
- 17:: (zusätzliche) Kapazität (der Hand)
- 18:: (elektrischer) Widerstand (der Hand)
- 19:: Wassertropfen / Wasser
- 20:: (elektrisch resistiver) Widerstand (von Wasser)
- 30:: Resonanzkurve (ohne Berührung)
- 31:: Resonanzkurve (mit leichter Berührung)
- 31':: Resonanzkurve (mit Berührung bei benetzter Betätigungsfläche)
- 32:: Resonanzkurve (mit stärkerer Berührung)
- 33:: Resonanzkurve (bei leichter Benetzung)
- 34:: Resonanzkurve (bei etwas größerer Benetzung)
- 35:: Resonanzkurve (bei mittlerer Benetzung)
- 36:: Resonanzkurve (bei starker Benetzung)
- 37:: Resonanzkurve (bei äußerst starker Benetzung)
- 38:: linker Zweig (der Resonanzkurve)

- 40:: Amplitude (von Messwert im Resonanzpunkt)
- 41:: Amplitude (von Messwert im Resonanzpunkt bei leichter Berührung)
- 42:: Amplitude (von Messwert im Resonanzpunkt bei stärkerer Berührung)
- 43:: Differenz (für Amplituden bei unbenetzter Betätigungsfläche)
- 44:: Differenz (für Amplituden bei benetzter Betätigungsfläche)
- 45:: Amplitude (von Messwert im Resonanzpunkt bei leichter Benetzung)
- 46:: Differenz (zwischen Messwerten auf Resonanzkurve bei Betätigung und unbeeinflussten Schwingkreis bei erster Anregungsfrequenz)
- 47:: Differenz (zwischen Messwerten auf Resonanzkurve bei Betätigung und unbeeinflussten Schwingkreis bei zweiter Anregungsfrequenz)
- 48:: Differenz (zwischen Messwerten auf Resonanzkurve bei erster Anregungsfrequenz und bei dritter Anregungsfrequenz, jeweils bei Betätigung)
- 50:: Sensorelektrode
- 51:: Emitterelektrode
- 52:: Anregungsfrequenz
- 53:: Gehäuse
- 54:: Steuer- und/oder Kontrolleinheit
- 55:: Antrieb

## Patentansprüche

1. Schaltbedienelement mit einer Betätigungsfläche (6) zur manuellen Einwirkung mittels eines Elements (7) und einem mit der Betätigungsfläche (6) derart zusammenwirkenden kapazitiv arbeitenden Sensor (9), dass der Sensor (9) ausgebildet ist, bei Annäherung des Elements (7) an die Betätigungsfläche (6) und/oder bei Berührung der Betätigungsfläche (6) mittels des Elements (7) und/oder bei Druckeinwirkung mittels des Elements (7) auf die Betätigungsfläche (6) ein Signal (10) zu erzeugen,
wobei das Signal (10) ein Schaltsignal und/oder Steuersignal zum Schalten und/oder Auslösen einer Funktion ist,
wobei der kapazitiv arbeitende Sensor (9) einen elektrischen Schwingkreis (11), einen Signalgenerator (12) zur Anregung des Schwingkreises (11) mit einer Anregungsfrequenz (fmess1), eine Messeinheit (13) zur Messung eines Messwertes des Schwingkreises (11) bei der Anregungsfrequenz (fmess1) sowie eine Auswerteeinheit (14) zur Erzeugung des Signals (10) in Abhängigkeit von der Änderung des Messwertes bei Einwirkung des Elements (7) auf die Betätigungsfläche (6) umfasst, wobei die Anregungsfrequenz (fmess1) kleiner als die Resonanzfrequenz (fres) des Schwingkreises (11) bei einer mit Wasser benetzten Betätigungsfläche (6) ist,
wobei der Signalgenerator (12) ausgebildet ist, den Schwingkreis (11) mit einer weiteren Anregungsfrequenz (fmess2) anzuregen,
die Messeinheit (13) ausgebildet ist, einen weiteren Messwert bei der weiteren Anregungsfrequenz (fmess2) zu messen,
und die Auswerteeinheit (14) ausgebildet ist, das Signal (10) lediglich dann zu erzeugen, wenn die Differenz (47) zwischen dem weiteren Messwert und einem Grenz-Messwert für den unbeeinflussten Schwingkreis (11) bei der weiteren Anregungsfrequenz (fmess2) einen vorgegebenen Grenz-Schwellwert unterschreitet.

2. Schaltbedienelement nach Anspruch 1, wobei die Anregungsfrequenz (fmess1) in einem Bereich von ca. 6 % bis 4 % unterhalb der Resonanzfrequenz (fres) gewählt ist.

3. Schaltbedienelement nach Anspruch 1 oder 2,
wobei die Auswerteeinheit (14) ausgebildet ist, das Signal lediglich dann zu erzeugen, wenn die Differenz (46) zwischen dem Messwert bei der Anregungsfrequenz (fmess1) und dem Basis-Messwert für den unbeeinflussten Schwingkreis bei der Anregungsfrequenz (fmess1) einen vorgegebenen Basis-Schwellwert übersteigt.

4. Schaltbedienelement nach einem der vorhergehenden Ansprüche,
wobei der durch die Messeinheit (13) gemessene Messwert des Schwingkreises (11) bei der Anregungsfrequenz (fmess1) die am Schwingkreis (11) anliegende elektrische Spannung und/oder der im Schwingkreis (11) fließende elektrische Strom ist.

5. Schaltbedienelement nach einem der vorhergehenden Ansprüche, wobei die weitere Anregungsfrequenz (fmess2) der Resonanzfrequenz (fres) des Schwingkreises (11) entspricht.

6. Schaltbedienelement nach einem der Ansprüche 1 bis 5, **dadurch gekennzeichnet, dass** der Signalgenerator (12) den Schwingkreis mit wenigstens einer in der Nähe zur Anregungsfrequenz (fmess1) liegenden noch weiteren Anregungsfrequenz (fmess3) anregt, dass die Messeinheit (13) einen noch weiteren Messwert bei der noch weiteren Anregungsfrequenz (fmess3) misst, und dass die Auswerteeinheit (14) das Signal (10) lediglich dann erzeugt, wenn die Differenz (48) zwischen dem noch weiteren Messwert und dem Messwert geringfügig ist, insbesondere wenn die Differenz (48) kleiner als ein vorgegebener Höchstwert ist.

7. Schaltbedienelement nach dem vorhergehenden Anspruch, wobei die noch weitere Anregungsfrequenz (fmess3) ±0,1 % bis ±0,6 % von der Anregungsfrequenz (fmess1) entfernt und insbesondere ±0,3 % bis ±0,6 % von der Anregungsfrequenz (fmess1) entfernt ist.

8. Schaltbedienelement nach einem der Ansprüche 1 bis 7, **dadurch gekennzeichnet, dass** der Schwingkreis (11) eine Induktivität (16) und mindestens eine Kapazität (15) umfasst, wobei insbesondere die Kapazität (15) und/oder die Induktivität (16) als gedruckte Schaltungsbestandteile gebildet sind, dass vorzugsweise die Kapazität (15) und/oder die Induktivität (16) auf einer Leiterplatte angeordnet sind, dass weiter vorzugsweise die Betätigungsfläche (6) eine Sensorelektrode (50) der Kapazität (15) ist, dass noch weiter vorzugsweise ein Gehäuse (53) mit einer Gehäusewand (6) vorgesehen ist, und dass nochmals weiter vorzugsweise die Gehäusewand (6) die Betätigungsfläche (6), insbesondere als eine Koppelkapazität zur Umgebung, ausbildet.

9. Schaltbedienelement nach einem der Ansprüche 1 bis 8, **dadurch gekennzeichnet, dass** eine Steuer- und/oder Kontrolleinheit (54) vorgesehen ist, dass vorzugsweise die Steuer- und/oder Kontrolleinheit (54) die Anregungsfrequenz am Signalgenerator (12) einstellt, dass weiter vorzugsweise die Auswerteeinheit (14) von der Steuer- und/oder Kontrolleinheit (54) gebildet ist, und dass es sich noch weiter vorzugsweise bei der Steuer- und/oder Kontrolleinheit (54) um einen Mikrocontroller oder einen Mikroprozessor handelt.

10. Schaltbedienelement nach einem der Ansprüche 1 bis 9, **dadurch gekennzeichnet, dass** ein Antrieb (55) für die Bewegung eines Verschlusselements, insbesondere für eine Türe, wie eine Autotüre (3), eine Heckklappe oder eine Frontklappe eines Kraftfahrzeugs (1), vorgesehen ist, und dass vorzugsweise das Schalt- und/oder Steuersignal (10) den Antrieb (55) ansteuert.

11. Verfahren zum Betrieb eines kapazitiven Sensors (9) mit einem elektrischen Schwingkreis (11),
wobei auf eine Betätigungsfläche (6) des Schaltbedienelements (5) mittels eines Elements (7), bei dem es sich insbesondere um eine menschliche Hand handelt, eingewirkt wird, derart dass bei Annäherung des Elements (7) an die Betätigungsfläche (6) und/oder bei Berührung der Betätigungsfläche (6) mittels des Elements (7) und/oder bei Druckeinwirkung mittels des Elements (7) auf die Betätigungsfläche (6) ein Signal (10) erzeugbar ist,
wobei der Schwingkreis (11) mit einer Anregungsfrequenz (fmess1) angeregt wird,
wobei ein Messwert des Schwingkreises (11) bei der Anregungsfrequenz (fmess1) gemessen wird,
und wobei die Änderung des Messwertes zur Erzeugung des Signals (10) ausgewertet wird,
wobei die Anregungsfrequenz (fmess1) kleiner als die Resonanzfrequenz (fres) des Schwingkreises (11) bei einer mit Wasser benetzten Betätigungsfläche (6) gewählt wird,
dass der Schwingkreis mit einer weiteren Anregungsfrequenz (fmess2) angeregt wird,
dass ein weiterer Messwert bei der weiteren Anregungsfrequenz (fmess2) gemessen wird,
und dass das Signal (10) lediglich dann erzeugt wird, wenn die Differenz (47) zwischen dem weiteren Messwert und einem Grenz-Messwert für den unbeeinflussten Schwingkreis (11) bei der weiteren Anregungsfrequenz (fmess2) einen vorgegebenen Grenz-Schwellwert unterschreitet.

12. Verfahren nach Anspruch 11, wobei die Anregungsfrequenz (fmess1) in einem Bereich von ca. 6 % bis 4 % unterhalb der Resonanzfrequenz (fres), bevorzugterweise bei 5 % unterhalb der Resonanzfrequenz (fres), gewählt wird.

13. Verfahren zur Betrieb eines kapazitiven Sensors (9) nach Anspruch 11 oder 12, **dadurch gekennzeichnet, dass** das Signal (10) lediglich dann erzeugt wird, wenn die Differenz (46) zwischen dem Messwert bei der Anregungsfrequenz (fmess1) und dem Basis-Messwert für den unbeeinflussten Schwingkreis bei der Anregungsfrequenz (fmess1) einen vorgegebenen Basis-Schwellwert überschreitet.

14. Verfahren zur Betrieb eines kapazitiven Sensors (9) nach Anspruch 11, 12 oder 13, **dadurch gekennzeichnet, dass** als Messwert des Schwingkreises (11) bei der Anregungsfrequenz (fmess1) die am Schwingkreis (1) anliegende elektrische Spannung und/oder der im Schwingkreis (11) fließende elektrische Strom gemessen wird.

15. Verfahren nach dem vorhergehenden Anspruch, wobei für die weitere Anregungsfrequenz (fmess2) die Resonanzfrequenz (fres) des Schwingkreises (11) gewählt wird.

## Claims

1. A switching operating element with an actuating surface (6) for manually acting on by means of an element (7) and a capacitively operating sensor (9) interacting with the actuating surface (6) in such a way that the sensor (9) is configured to generate a signal (10) when the element (7) approaches the actuating surface (6) and/or when the actuating surface (6) is contacted by means of the element (7) and/or when pressure acts on the actuating surface (6) by means of the element (7),
wherein the signal (10) is a switching signal and/or control signal for switching and/or triggering a function,
wherein the capacitively operating sensor (9) comprises an electrical resonant circuit (11), a signal generator (12) for exciting the resonant circuit (11) at an excitation frequency (fmess1), a measuring unit (13) for measuring a measured value of the resonant circuit (11) at the excitation frequency (fmess1), and an evaluation unit (14) for generating the signal (10) as a function of the change in the measured value when the element (7) acts on the actuating surface (6), wherein the excitation frequency (fmess1) is lower than the resonant frequency (fres) of the resonant circuit (11) in the case of an actuating surface (6) wetted with water,
wherein the signal generator (12) is configured to excite the resonant circuit (11) with a further excitation frequency (fmess2),
the measuring unit (13) is configured to measure a further measured value at the further excitation frequency (fmess2),
and the evaluation unit (14) is configured to generate the signal (10) only when the difference (47) between the further measured value and a limit measured value for the uninfluenced resonant circuit (11) at the further excitation frequency (fmess2) falls below a predetermined limit threshold.

2. The switching operating element according to claim 1, wherein the excitation frequency (fmess1) is selected in a range of about 6% to 4% below the resonant frequency (fres).

3. The switching operating element according to claim 1 or 2,
wherein the evaluation unit (14) is configured to generate the signal only when the difference (46) between the measured value at the excitation frequency (fmess1) and the base measured value for the uninfluenced resonant circuit at the excitation frequency (fmess1) exceeds a predetermined base threshold.

4. The switching operating element according to any one of the preceding claims,
wherein the measured value of the resonant circuit (11) measured by the measuring unit (13) at the excitation frequency (fmess1) is the electrical voltage applied to the resonant circuit (11) and/or the electrical current flowing in the resonant circuit (11).

5. The switching operating element according to any one of the preceding claims, wherein the further excitation frequency (fmess2) corresponds to the resonant frequency (fres) of the resonant circuit (11).

6. The switching operating element according to any one of claims 1 to 5, **characterised in that** the signal generator (12) excites the resonant circuit with at least one yet further excitation frequency (fmess3) proximate to the excitation frequency (fmess1), that the measuring unit (13) measures a yet further measured value at the yet further excitation frequency (fmess3), and that the evaluation unit (14) generates the signal (10) only when the difference (48) between the yet further measured value and the measured value is small, particularly if the difference (48) is smaller than a predetermined maximum value.

7. The switching operating element according to the preceding claim, wherein the yet further excitation frequency (fmess3) is spaced apart from the excitation frequency (fmess1) by ±0.1% to ±0.6% and particularly spaced apart from the excitation frequency (fmess1) by ±0.3% to ±0.6%.

8. The switching operating element according to any one of claims 1 to 7, **characterised in that** the resonant circuit (11) comprises an inductance (16) and at least one capacitance (15), the capacitance (15) and/or the inductance (16) being configured as printed circuit components, that the capacitance (15) and/or the inductance (16) is/are preferably arranged on a printed circuit board, that the actuating surface (6) further preferably is a sensor electrode (50) of the capacitance (15), that a housing (53) having a housing wall (6) is yet further preferably provided, and that the housing wall (6) yet even further preferably forms the actuating surface (6), particularly as a coupling capacitance to the environment.

9. The switching operating element according to any one of claims 1 to 8, **characterised in that** a control and/or monitoring unit (54) is provided, that the control and/or monitoring unit (54) preferably adjusts the excitation frequency at the signal generator (12), that the evaluation unit (14) is further preferably formed by the control and/or monitoring unit (54), and that the control and/or monitoring unit (54) yet further preferably is a microcontroller or a microprocessor.

10. The switching operating element according to claim 1 to 9, **characterised in that** a drive (55) is provided for moving a closure element, particularly for a door, such as an automobile door (3), a tailgate or a front gate of a motor vehicle (1), and the switching and/or control signal (10) preferably actuates the drive (55).

11. A method for operating a capacitive sensor (9) with an electrical resonant circuit (11),
wherein an actuation surface (6) of the switching operating element (5) is acted upon by means of an element (7), which particularly is a human hand, such that a signal (10) is generatable when the element (7) approaches the actuation surface (6) and/or when the actuation surface (6) is contacted by means of the element (7) and/or when pressure acts on the actuation surface (6) by means of the element (7),
wherein the resonant circuit (11) is excited with an excitation frequency (fmess1),
wherein a measured value of the resonant circuit (11) is measured at the excitation frequency (fmess1),
and wherein the change in the measured value is evaluated for generating the signal (10),
wherein the excitation frequency (fmess1) is selected to be lower than the resonant frequency (fres) of the resonant circuit (11) in the case of an actuating surface (6) wetted with water,
that the resonant circuit is excited with a further excitation frequency (fmess2);
that a further measured value is measured at the further excitation frequency (fmess2),
and that the signal (10) is generated only when the difference (47) between the further measured value and a limit measured value for the uninfluenced resonant circuit (11) at the further excitation frequency (fmess2) falls below a predetermined limit threshold.

12. The method according to claim 11, wherein the excitation frequency (fmess1) is selected in a range of about 6% to 4% below the resonant frequency (fres), preferably at 5% below the resonant frequency (fres).

13. The method for operating a capacitive sensor (9) according to claim 11 or 12, **characterised in that** the signal (10) is generated only when the difference (46) between the measured value at the excitation frequency (fmess1) and the base measured value for the uninfluenced resonant circuit at the excitation frequency (fmess1) exceeds a predetermined base threshold.

14. The method for operating a capacitive sensor (9) according to claim 11, 12, or 13, **characterised in that** the electrical voltage applied to the resonant circuit (1) and/or the electrical current flowing in the resonant circuit (11) is measured as the measured value of the resonant circuit (11) at the excitation frequency (fmess1).

15. The method according to the preceding claim, wherein the resonant frequency (fres) of the resonant circuit (11) is selected for the further excitation frequency (fmess2).

## Revendications

1. Élément de commande de commutation doté d'une surface d'actionnement (6) pour une action manuelle au moyen d'un élément (7), et d'un capteur capacitif (9) coopérant avec la surface d'actionnement (6) de sorte que le capteur (9) est conçu pour générer un signal (10) lors de l'approche de l'élément (7) vers la surface d'actionnement (6) et/ou lors du contact avec la surface d'actionnement (6) au moyen de l'élément (7) et/ou lors de l'application d'une pression sur la surface d'actionnement (6) au moyen de l'élément (7),
dans lequel le signal (10) est un signal de commutation et/ou un signal de commande destiné à commuter et/ou à déclencher une fonction,
dans lequel le capteur capacitif (9) comprend un circuit oscillant électrique (11), un générateur de signaux (12) pour l'excitation du circuit oscillant (11) avec une fréquence d'excitation (fmess1), une unité de mesure (13) pour mesurer une valeur de mesure du circuit oscillant (11) à la fréquence d'excitation (fmess1), ainsi qu'une unité d'évaluation (14) pour générer le signal (10) en fonction de la variation de la valeur de mesure lors de l'action de l'élément (7) sur la surface d'actionnement (6), dans lequel la fréquence d'excitation (fmess1) est inférieure à la fréquence de résonance (fres) du circuit oscillant (11) lorsque la surface d'actionnement (6) est mouillée avec de l'eau,
dans lequel le générateur de signaux (12) est conçu pour exciter le circuit oscillant (11) avec une autre fréquence d'excitation (fmess2),
dans lequel l'unité de mesure (13) est conçue pour mesurer une autre valeur de mesure à l'autre fréquence d'excitation (fmess2),
et dans lequel l'unité d'évaluation (14) est conçue pour générer le signal (10) uniquement lorsque la différence (47) entre l'autre valeur de mesure et une valeur de mesure limite pour le circuit oscillant (11) non influencé à l'autre fréquence d'excitation (fmess2) devient inférieure à une valeur de seuil limite prédéfinie.

2. Élément de commande de commutation selon la revendication 1, dans lequel la fréquence d'excitation (fmess1) est choisie dans une plage d'environ 6 % à 4 % en dessous de la fréquence de résonance (fres).

3. Élément de commande de commutation selon la revendication 1 ou 2,
dans lequel l'unité d'évaluation (14) est conçue pour générer le signal uniquement lorsque la différence (46) entre la valeur de mesure à la fréquence d'excitation (fmess1) et la valeur de mesure de base pour le circuit oscillant non influencé à la fréquence d'excitation (fmess1) dépasse une valeur de seuil de base prédéfinie.

4. Élément de commande de commutation selon l'une quelconque des revendications précédentes,
dans lequel la valeur de mesure du circuit oscillant (11) mesurée par l'unité de mesure (13) à la fréquence d'excitation (fmess1) est la tension électrique appliquée au circuit oscillant (11) et/ou le courant électrique circulant dans le circuit oscillant (11).

5. Élément de commande de commutation selon l'une quelconque des revendications précédentes, dans lequel l'autre fréquence d'excitation (fmess2) correspond à la fréquence de résonance (fres) du circuit oscillant (11).

6. Élément de commande de commutation selon l'une quelconque des revendications 1 à 5, **caractérisé en ce que** le générateur de signaux (12) excite le circuit oscillant avec au moins une fréquence d'excitation supplémentaire (fmess3) se situant à proximité de la fréquence d'excitation (fmess1), **en ce que** l'unité de mesure (13) mesure une valeur de mesure supplémentaire à ladite fréquence d'excitation supplémentaire (fmess3), et **en ce que** l'unité d'évaluation (14) génère le signal (10) uniquement lorsque la différence (48) entre ladite valeur de mesure supplémentaire et la valeur de mesure est minime, en particulier lorsque la différence (48) est inférieure à une valeur maximale prédéfinie.

7. Élément de commande de commutation selon la revendication précédente, dans lequel ladite fréquence d'excitation supplémentaire (fmess3) est éloignée de ±0,1 % à ±0,6 % de la fréquence d'excitation (fmess1) et en particulier éloignée de ±0,3 % à ±0,6 % de la fréquence d'excitation (fmess1).

8. Élément de commande de commutation selon l'une quelconque des revendications 1 à 7, **caractérisé en ce que** le circuit oscillant (11) comprend une inductance (16) et au moins une capacité (15), dans lequel en particulier la capacité (15) et/ou l'inductance (16) sont formées en tant que composants de circuit imprimé, **en ce que**, de préférence, la capacité (15) et/ou l'inductance (16) sont agencées sur une carte de circuit imprimé, **en ce que**, de préférence encore, la surface d'actionnement (6) est une électrode de capteur (50) de la capacité (15), **en ce que**, de manière particulièrement préférée, il est prévu un boîtier (53) doté d'une paroi de boîtier (6), et **en ce que**, très avantageusement, la paroi de boîtier (6) forme la surface d'actionnement (6), en particulier en tant que capacité de couplage avec l'environnement.

9. Élément de commande de commutation selon l'une quelconque des revendications 1 à 8, **caractérisé en ce qu'**il est prévu un dispositif de commande et/ou de contrôle (54), **en ce que**, de préférence, le dispositif de commande et/ou de contrôle (54) règle la fréquence d'excitation sur le générateur de signaux (12), **en ce que**, de préférence encore, l'unité d'évaluation (14) est formée par le dispositif de commande et/ou de contrôle (54), et **en ce que**, de manière particulièrement préférée, le dispositif de commande et/ou de contrôle (54) est un microcontrôleur ou un microprocesseur.

10. Élément de commande de commutation selon l'une quelconque des revendications 1 à 9, **caractérisé en ce qu'**il est prévu un entraînement (55) pour le mouvement d'un élément de fermeture, en particulier pour une porte, telle qu'une porte de voiture (3), un hayon ou un capot avant d'un véhicule automobile (1), et **en ce que**, de préférence, le signal de commutation et/ou de commande (10) commande l'entraînement (55).

11. Procédé de fonctionnement d'un capteur capacitif (9) pourvu d'un circuit oscillant électrique (11),
dans lequel la surface d'actionnement (6) de l'élément de commande de commutation (5) subit l'action d'un élément (7), qui est en particulier une main humaine, de telle sorte que, lors de l'approche de l'élément (7) vers la surface d'actionnement (6) et/ou lors du contact avec la surface d'actionnement (6) au moyen de l'élément (7) et/ou lors de l'application d'une pression sur la surface d'actionnement (6) au moyen de l'élément (7), un signal (10) peut être généré,
dans lequel le circuit oscillant (11) est excité avec une fréquence d'excitation (fmess1),
dans lequel une valeur de mesure du circuit oscillant (11) est mesurée à la fréquence d'excitation (fmess1),
et dans lequel la variation de la valeur de mesure est évaluée pour générer le signal (10),
dans lequel la fréquence d'excitation (fmess1) est choisie de manière à être inférieure à la fréquence de résonance (fres) du circuit oscillant (11) lorsque la surface d'actionnement (6) est mouillée avec de l'eau,
dans lequel le circuit oscillant est excité avec une autre fréquence d'excitation (fmess2),
dans lequel une autre valeur de mesure est mesurée à l'autre fréquence d'excitation (fmess2),
et dans lequel le signal (10) est généré uniquement lorsque la différence (47) entre l'autre valeur de mesure et une valeur de mesure limite pour le circuit oscillant (11) non influencé à l'autre fréquence d'excitation (fmess2) devient inférieure à une valeur de seuil limite prédéfinie.

12. Procédé selon la revendication 11, dans lequel la fréquence d'excitation (fmess1) est choisie dans une plage d'environ 6 % à 4 % en dessous de la fréquence de résonance (fres), de manière préférée à 5 % en dessous de la fréquence de résonance (fres).

13. Procédé de fonctionnement d'un capteur capacitif (9) selon la revendication 11 ou 12, **caractérisé en ce que** le signal (10) est généré uniquement lorsque la différence (46) entre la valeur de mesure à la fréquence d'excitation (fmess1) et la valeur de mesure de base pour le circuit oscillant non influencé à la fréquence d'excitation (fmess1) dépasse une valeur de seuil de base prédéfinie.

14. Procédé de fonctionnement d'un capteur capacitif (9) selon la revendication 11, 12 ou 13, **caractérisé en ce que** la tension électrique appliquée au circuit oscillant (11) et/ou le courant électrique circulant dans le circuit oscillant (1) sont mesurés en tant que valeur de mesure du circuit oscillant (11) à la fréquence d'excitation (fmess1).

15. Procédé selon la revendication précédente, dans lequel on choisit la fréquence de résonance (fres) du circuit oscillant (11) pour l'autre fréquence d'excitation (fmess2).
